# EUROPÄISCHE PATENTSCHRIFT

(11) **EP 0 706 056 B1**
(45) Veröffentlichungstag und Bekanntmachung des Hinweises auf die Patenterteilung: **26.05.2004**
(21) Anmeldenummer: 95810588.4
(22) Anmeldetag: 20.09.1995
(51) Int. Cl.: G01R 31/12, G01R 29/08, G01R 15/14

(54) **Sensor zum Auskoppeln von Teilentladungsimpulsen aus einer hochspannungsführenden elektrischen Anlage**
Sensor for detecting partial discharge impulses in high voltage equipment
Capteur pour détecter des impulsions de décharge partielle dans un appareillage à haute tension

(30) Priorität: 04.10.1994 DE 4435442
(43) Veröffentlichungstag der Anmeldung: 10.04.1996
(73) Patentinhaber: ABB Schweiz AG, 5400 Baden (CH)
(72) Erfinder: Behrmann, Glenn, CH-5708 Birrwil (CH); Kaczkowski, Andrzej, Dr., CH-5303 Würenlingen (CH)
(74) Vertreter: ABB Patent Attorneys

(56) Entgegenhaltungen:
- EP-A- 0 134 187
- EP-A- 0 522 303
- DE-A- 4 126 868
- PATENT ABSTRACTS OF JAPAN Bd. 15, Nr. 210 (P-1208) 29 Mai 1991 & JP-A-03 057 977 (MEIDENSHA CORP) 13 M{rz 1991
- PATENT ABSTRACTS OF JAPAN Bd. 14, Nr. 496 (E-996) 29 Oktober 1990 & JP-A-02 206 340 (HITACHI) 16 August 1990

## Beschreibung

### TECHNISCHES GEBIET

Bei der Erfindung wird von einem Sensor zum Auskoppeln von Teilentladungsimpulsen aus einer hochspannungsführenden elektrischen Anlage gemäss dem Oberbegriff des Anspruchs 1 ausgegangen. Insbesondere wird der Sensor in einer metallgekapselten gasisolierten Hochspannungsanlage eingesetzt. Der Sensor kann aber beispielsweise auch zur Überwachung von Transformatoren, Hochspannungskabeln oder sonstigen spannungsführenden Baugruppen oder Anlagen eingesetzt werden.

### STAND DER TECHNIK

Die Erfassung von Teilentladungen spielt bei der Qualitätssicherung von hochspannungsführenden elektrischen Anlagen, wie etwa einer metallgekapselten gasisolierten Hochspannungsanlage oder einem hochspannungsbeaufschlagten elektrischen Gerät, beispielsweise einem Transformator oder einem Generator, eine wichtige Rolle. Teilentladungsmessungen werden sowohl bei der Qualitätskontrolle während der Fertigung in der Fabrik als auch bei der Qualitätsprüfung während des Vor-Ort-Aufbaus der metallgekapselten gasisolierten Schaltanlage oder des betreffenden Geräts durchgeführt.

Ein Sensor zum Auskoppeln von Teilentladungsimpulsen aus einer hochspannungsführenden elektrischen Anlage ist beispielsweise aus der Patentanmeldung EP 0 134 187 A2 bekannt. Der vorbekannte Sensor weist eine als Metallplatte ausgebildete Messelektrode auf, die in die innere Oberfläche der Metallkapselung einer gasisolierten metallgekapselten Hochspannungsanlage eingelassen ist. Von der Metallkapselung ist der Sensor allerdings elektrisch isoliert. Die von dem Sensor aus dieser hochspannungsführenden Anlage kapazitiv ausgekoppelten Teilentladungsimpulse werden in einer dem Sensor nachgeschalteten Signalverarbeitungsvorrichtung weiter verarbeitet. Ein derartiger Sensor ist nicht in der Lage die Propagationsrichtung des jeweiligen Teilentladungsimpulses zu erfassen.

DE 4 126 868 A offenbart eine Vorrichtung zum Erfassen von Teilentladungsimpulsen, wobei die Propagationsrichtung der Teilentladungsimpulse bestimmt wird. Dabei werden die Polaritäten des elektrischen und magnetischen Felds benötigt.

### KURZE DARSTELLUNG DER ERFINDUNG

Der Erfindung, wie sie in Patentanspruch 1 definiert ist, liegt die Aufgabe zugrunde, einen Sensor der eingangs genannten Art zu schaffen, welcher sich einerseits durch einen hohen Wirkungsgrad bei der Auskoppelung der in der Anlage auftretenden Teilentladungsimpulse auszeichnet, und der es andererseits ermöglicht, die Propagationsrichtung der Teilentladungsimpulse zu bestimmen. Ferner soll ein Verfahren angegeben werden, bei welchem dieser Sensor eingesetzt wird.

Mit dem erfindungsgemässen Sensor ist es möglich, mit hoher Genauigkeit zu erkennen, auf welcher Seite des Sensors die jeweilige Teilentladungsquelle liegt, sodass der Aufwand für die Suche der Fehlerstelle vorteilhaft reduziert wird.

Der Sensor zum Auskoppeln von Teilentladungsimpulsen aus einer hochspannungsführenden elektrischen Anlage, insbesondere einer metallgekapselten gasisolierten Hochspannungsanlage, wirkt mit mindestens einer Signalverarbeitungsvorrichtung zusammen. Der Sensor ist sowohl für die Nutzung des elektrischen Felds als auch für die Nutzung des magnetischen Felds für die Detektion von Teilentladungsimpulsen ausgelegt.

Der Sensor weist zwei Teilsensoren mit jeweils mindestens einer flächig ausgebildeten, dem elektromagnetischen Feld der Anlage ausgesetzte, Messelektrode auf. Jeder der zwei Teilsensoren ist mit Mitteln für die Detektion des magnetischen Felds versehen. Die Signalverarbeitungsvorrichtung weist für jeden der zwei Teilsensoren jeweils mindestens einen separaten Eingang auf. Auf diese Art ist es möglich einen Sensor zu schaffen, der einen vorteilhaft kleinen Platzbedarf aufweist.

Die zwei Teilsensoren sind identisch aufgebaut, ferner sind sie um 180° gegeneinander verdreht montiert. Als besonders einfaches Mittel für die Detektion des magnetischen Felds ist pro Teilsensor mindestens eine elektrisch leitende Windung vorgesehen.

Es wird ein Verfahren zur Bestimmung der Propagationsrichtung von Teilentladungsimpulsen angegeben, welches dadurch gekennzeichnet ist, dass im hierfür verwendeten Sensor sowohl das elektrische Feld als das magnetische Feld für die Detektion der Teilentladungsimpulse genutzt wird. Bei diesem Verfahren generiert jeweils nur ein erster Eingang der mit dem Sensor zusammenwirkenden Signalverarbeitungsvorrichtung einen relevanten Messimpuls, bei dem zuerst ein vorgegebener Schwellwert erreicht oder überschritten wird. Ein mindestens zweiter Eingang wird danach sofort während einer vorgegebenen Zeitspanne gesperrt. Ferner wird nach dem Speichern des Messimpulses in einer Speicher- und Verarbeitungseinheit der erste Eingang gleichfalls während einer vorgegebenen Zeitspanne gesperrt. Durch diese Blockierungen wird eine mehrdeutige Messung mit grosser Sicherheit vermieden.

Der erfindungsgemässe Sensor weist ferner einen grossen Störabstand zu den in Hochspannungsanlagen auftretenden niederfrequenten Störungen auf.

Die weiteren Ausgestaltungen der Erfindung sind Gegenstände der abhängigen Ansprüche.

Die Erfindung, ihre Weiterbildung und die damit erzielbaren Vorteile werden nachstehend anhand der Zeichnung, welche lediglich einen möglichen Ausführungsweg darstellt, näher erläutert.

### KURZE BESCHREIBUNG DER ZEICHNUNG

Es zeigen:
Fig.1 in stark vereinfachter, schematischer Darstellung einen Ausschnitt aus der Wand einer metallgekapselten gasisolierten Hochspannungsanlage mit eingelassenem Sensor zum Auskoppeln von Teilentladungsimpulsen nach der Erfindung,
Fig.2 eine schematisch dargestellte Ansicht einer metallgekapselten gasisolierten Hochspannungsanlage mit einem eingebauten Sensor,
Fig.3 eine schematisch dargestellte Ansicht eines Teils einer weiteren Ausführungsform eines erfindungsgemässen Sensors,
Fig.4 eine schematisch dargestellte Signalverarbeitungsvorrichtung, und
Fig.5 von dem Sensor aufgenommene und einander überlagerte Signale.

Bei allen Figuren sind gleich wirkende Elemente mit gleichen Bezugszeichen versehen. Alle für das unmittelbare Verständnis der Erfindung nicht erforderlichen Elemente sind nicht dargestellt.

### WEGE ZUR AUSFÜHRUNG DER ERFINDUNG

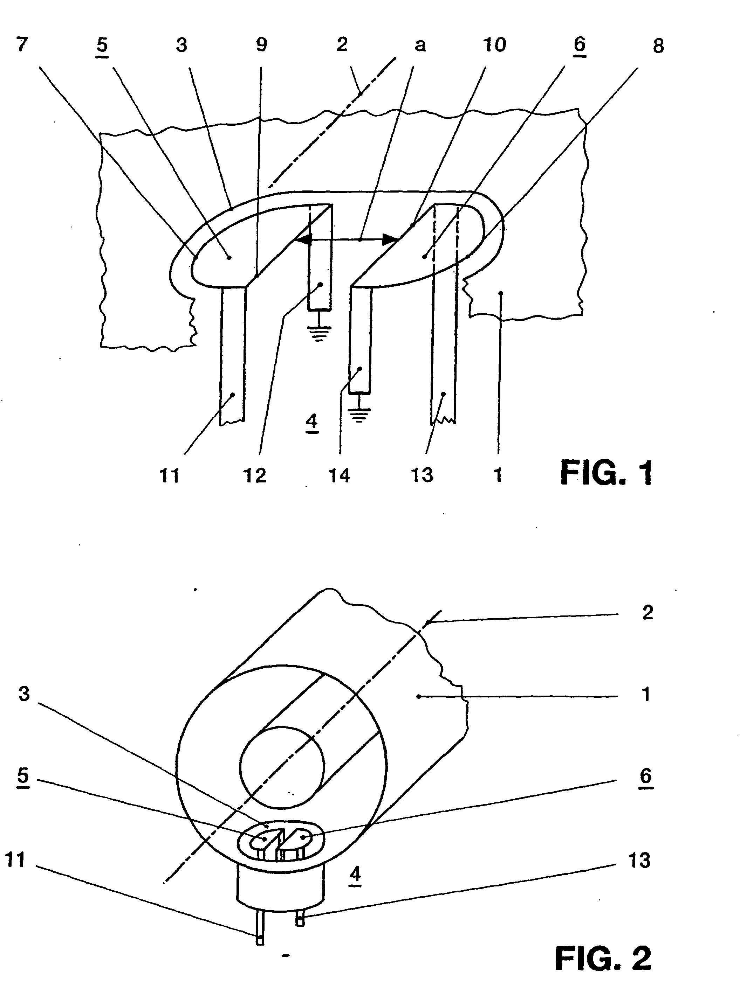

In Fig.1 ist in stark vereinfachter, schematischer Darstellung ein Ausschnitt aus der Gehäusewand einer metallgekapselten gasisolierten Hochspannungsanlage dargestellt. Die metallgekapselte gasisolierte Hochspannungsanlage weist ein Gehäuse 1 auf. Das Gehäuse 1 ist als Metallkapselung ausgebildet, die auf Erdpotential gelegt und mit einem Isoliergas, wie beispielsweise SF₆, unter Druck gefüllt ist. Ein ein von nicht dargestellten Isolatoren getragener und auf Hochspannungspotential liegender Leiter ist durch seine Mittelachse 2 angedeutet. Die metallgekapselte gasisolierte Hochspannungsanlage kann ein oder mehrphasig ausgebildet sein. Das Gehäuse 1 weist in der Innenwand eine Vertiefung 3 auf. In die Vertiefung 3 ist ein Sensor 4 eingelassen. Der Sensor 4 ist zum Auskoppeln von Teilentladungsimpulsen vorgesehen.

Der Sensor 4 weist hier zwei Teilsensoren 5,6 auf, die gleich aufgebaut sind, die jedoch um 180° gegeneinander verdreht und voneinander beabstandet in die Vertiefung 3 eingebaut sind. Jeder dieser Teilsensoren 5,6 weist eine flächig ausgebildete Messelektrode 7,8 auf, die hier beispielsweise die Form einer halbkreisförmigen ebenen Metallplatte aufweist, deren Oberfläche der Mittelachse 2 zugewandt ist. Die Messelektroden 7,8 liegen gemeinsam in einer Ebene, die sich parallel zu einer Ebene erstreckt, in welcher die Mittelachse 2 liegt. Die Oberflächen der Messelektroden 7,8 können auch der Kontur der Gehäuseinnenwand angepasst sein, in jedem Fall sollten die Kanten der Messelektroden 7,8 nicht über diese Kontur hinaus in den Innenraum des Gehäuses 1 ragen, um dielektrische Probleme zu vermeiden. Die geraden Kanten 9,10 der beiden halbkreisförmigen Messelektroden 7,8 verlaufen parallel zueinander mit einem Abstand a. Die beiden geraden Kanten 9,10 liegen in einer Ebene, die sich parallel zu einer Ebene erstreckt, in welcher die Mittelachse 2 liegt, und sie verlaufen parallel zur Mittelachse 2.

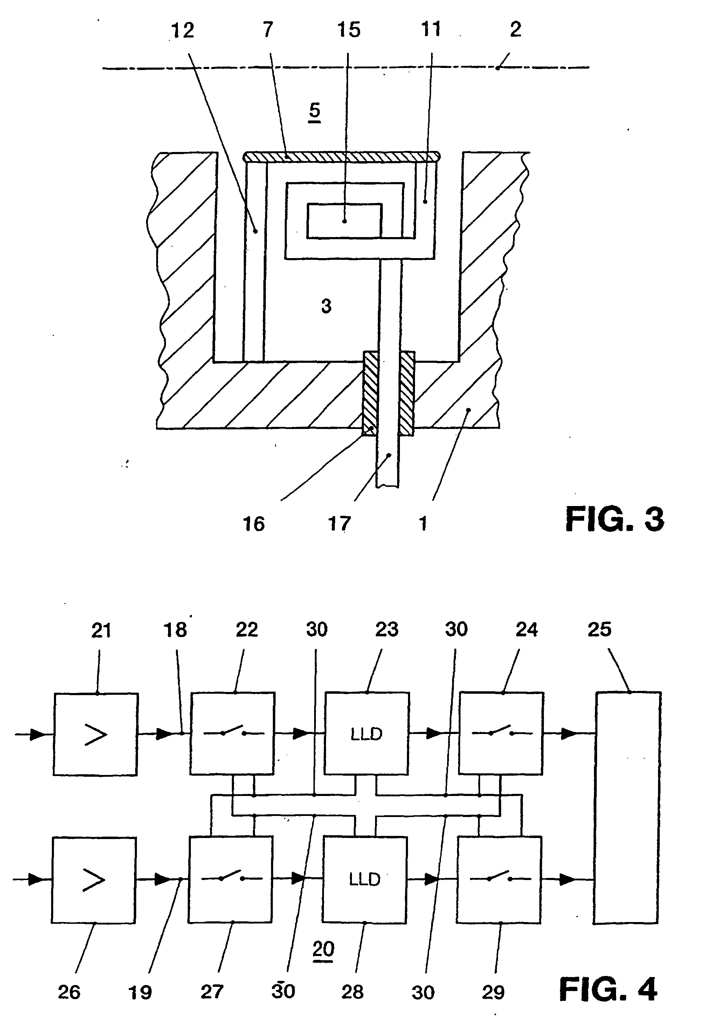

Die Messelektrode 7 weist zwei elektrische Anschlüsse 11,12 auf, die im Bereich der beiden Enden der geraden Kante 9 elektrisch leitend mit der Messelektrode 7 verbunden sind. Der erste Anschluss 11 wird elektrisch isoliert aus dem Gehäuse 1 heraus in eine in Fig.4 dargestellte Signalverarbeitungsvorrichtung 20 geführt, wobei diese Verbindung in der Regel ausserhalb des Gehäuses 1 mittels eines Koaxialkabels erfolgt. Der zweite Anschluss 12 ist mit der Innenwand des geerdeten Gehäuses 1 elektrisch leitend verbunden. Die übrigen Komponenten des Teilsensors 5 haben keinen elektrischen Kontakt mit dem Gehäuse 1.

Die Messelektrode 8 weist zwei elektrische Anschlüsse 13,14 auf, die im Bereich der beiden Enden der geraden Kante 10 elektrisch leitend mit der Messelektrode 8 verbunden sind. Der erste Anschluss 13 wird elektrisch isoliert aus dem Gehäuse 1 heraus ebenfalls in die erwähnte Signalverarbeitungsvorrichtung 20 geführt, wobei diese Verbindung in der Regel ausserhalb des Gehäuses 1 mittels eines Koaxialkabels erfolgt. Der zweite Anschluss 14 ist mit der Innenwand des geerdeten Gehäuses 1 elektrisch leitend verbunden. Die übrigen Komponenten des Teilsensors 6 haben keinen elektrischen Kontakt mit dem Gehäuse 1.

Die Anschlüsse 11 und 12 und die Kante 9 liegen ebenso wie die Anschlüsse 13 und 14 und die Kante 10 in jeweils einer Ebene, wobei sich diese Anschlüsse in die der Mittelachse 2 entgegengesetzte Richtung erstrecken. Diese Ebenen können jeweils durch die Mittelachse 2 verlaufen, sie können jedoch auch parallel zu einer derartigen Ebene verlaufen, und zwar je im Abstand ½•a von dieser Ebene. Die geerdeten Anschlüsse 12 und 14 der beiden Teilsensoren 5 und 6 sind auf den jeweils entgegengesetzten Seiten der Kanten 9 und 10 der Messelektroden 7 und 8 angeordnet und ebenso die isoliert nach aussen geführten Anschlüsse 11 und 13. Diese Anschlussgeometrie stellt eine elektrisch leitende Windung dar, und die Teilsensoren 5 und 6 arbeiten im Hinblick auf die Detektion magnetischer Felder besonders wirksam, wenn die Feldlinien dieser Felder die jeweilige Windung senkrecht oder annähernd senkrecht durchdringen.

Die Fig.2 zeigt eine schematisch dargestellte Ansicht eines Teiles einer metallgekapselten gasisolierten Hochspannungsanlage mit einem eingebauten Sensor 4 gemäss Fig.1. Aus dieser Figur ist deutlich zu erkennen, dass die geraden Kanten 9,10 der Messelektroden 7 und 8 parallel zu der Mittelachse 2 der Hochspannungsanlage verlaufen.

In der Fig.3 ist ein Schnitt durch den Teilsensor 5 dargestellt, der parallel zu der Ebene in welcher die Anschlüsse 11 und 12 und die Kante 9 liegen, geführt wurde. Der Anschluss 11 ist hier beispielsweise mit einer in einer Ebene parallel zur Schnittebene liegenden Windung versehen. Diese Windung schliesst eine Fläche 15 ein. Es können auch mehrere Windungen vorgesehen werden. Eine Erhöhung der Anzahl Windungen führt zu einer Reduktion der Arbeitsfrequenz des Sensors, sodass gezielt die für die angestrebten Einsatzbereiche des Sensors relevanten Frequenzbereiche eingestellt werden können. Ferner ist es möglich, auch den Anschluss 12 mit einer oder mehreren Windungen zu versehen. Der Anschluss 11 wird mit Hilfe einer elektrisch isolierenden, gas- und druckdichten Durchführung 16 durch die Wand des Gehäuses 1 nach draussen geführt. Das Ende 17 des Anschlusses 11 wird beim Austritt als Seele in ein nicht dargestelltes, abgeschirmtes Koaxialkabel eingeführt, um eine Beeinflussung der in die Signalverarbeitungsvorrichtung 20 übertragenen Signale durch äussere Störsignale zu verhindern. Vorzugsweise wird hierfür ein abgeschirmtes 50Ω-Koaxialkabel verwendet.

Die beiden Teilsensoren 5 und 6 werden in der Regel genau gleich aufgebaut, die geometrischen Abmessungen der Messelektroden 7 und 8 und auch die Anzahl und die Abmessungen der Windungen in den jeweiligen Anschlüssen 11 und 13, bzw. 12 und 14, sind gleich. Für besondere Anwendungen ist es jedoch auch vorstellbar, dass die Teilsensoren 5,6 unterschiedlich aufgebaut sind, wobei dann jedoch die Elektronik der zugehörigen Signalverarbeitungsvorrichtung 20, in welcher die Signale weiter verarbeitet werden, entsprechend ausgelegt sein muss.

Jeder dieser beiden herausgeführten Anschlüsse 11 und 13 wird in einen separaten Zweig 18,19 der in Fig.4 schematisch dargestellten Signalverarbeitungsvorrichtung 20 geleitet. Der erste Zweig 18 ist mit dem Anschluss 11 des Teilsensors 5 elektrisch leitend verbunden, der zweite Zweig 19 ist mit dem Anschluss 13 des Teilsensors 6 elektrisch leitend verbunden.

Der erste Zweig 18 ist aus einer Reihenschaltung eines Eingangsverstärkers 21, eines ersten Gates 22, eines Niveaudetektors (Locking Level Detector LLD) 23 und eines weiteren Gates 24 aufgebaut. Der erste Zweig 18 mündet in eine Speicher- und Verarbeitungseinheit 25 ein. Der zweite Zweig 19 ist aus einer Reihenschaltung eines Eingangsverstärkers 26, eines ersten Gates 27, eines Niveaudetektors (Locking Level Detector LLD) 28 und eines weiteren Gates 29 aufgebaut, er mündet ebenfalls in die Speicher- und Verarbeitungseinheit 25 ein. Die beiden Zweige 18 und 19 sind mittels eines Verbindungsnetzwerks 30 elektrisch leitend so miteinander verbunden, dass, sobald einer der Zweige 18,19 ein relevantes Signal detektiert hat, der jeweils andere Zweig eine vorbestimmte Zeit für die Verarbeitung von in diesem Zweig eintreffenden Signalen gesperrt ist. Dieses Verbindungsnetzwerk 30 stellt eine in der Messtechnik gebräuchliche Schaltung dar und wird deshalb hier nicht weiter beschrieben.

Zur Erläuterung der Wirkungsweise wird nun die Fig.1 näher betrachtet. Der Sensor 4 ist vorgesehen für das Auskoppeln von Teilentladungsimpulsen aus einer hochspannungsführenden elektrischen Anlage, er arbeitet deshalb in einem Frequenzbereich von etwa 10 MHz bis etwa 300 MHz. Die genaue Bandbreite wird durch die geometrischen Abmessungen des Sensors 4 bestimmt. Durch die Anpassung der Abmessungen des Sensors 4 können auch andere Frequenzbereiche eingestellt werden. Bei der Betriebsfrequenz der Hochspannungsanlage ist der Sensor 4 nicht wirksam.

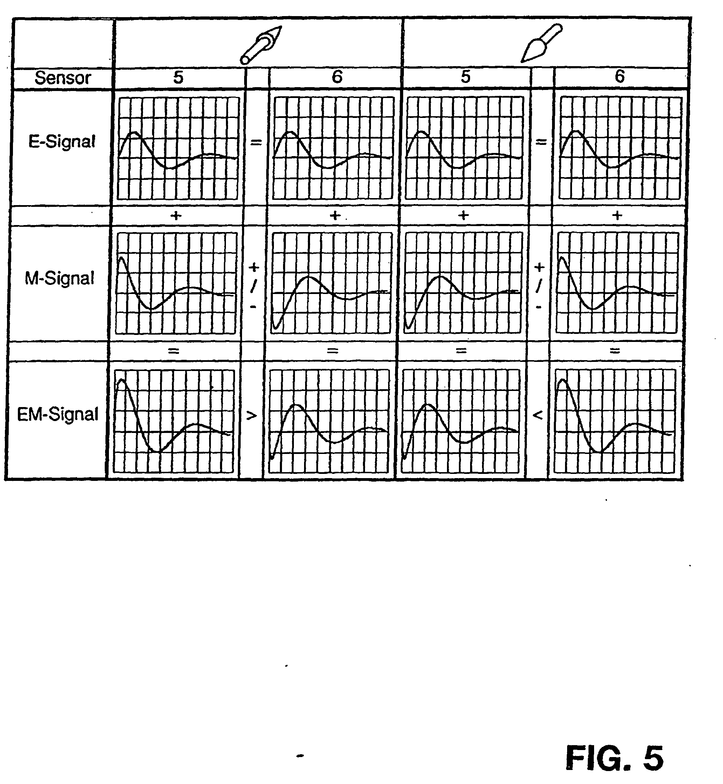

Wenn transiente elektromagnetische Felder, wie sie zum Beispiel durch hochfrequente Teilentladungsimpulse verursacht werden, in der durch den Sensor 4 überwachten Hochspannungsanlage auftreten, so wandern sie durch die Hochspannungsanlage. Die räumliche Zuordnung der Vektoren, die dem elektrischen Feld und dem magnetischen Feld zugeordnet sind, ist von der Propagationsrichtung der Teilentladungsimpulse abhängig. Aus den in Fig.5 dargestellten unterschiedlichen Signalverläufen ist zu ersehen, wie auf die Propagationsrichtung geschlossen werden kann. Die zu detektierende Teilentladungsquelle ist dann jeweils auf der Seite des Sensors 4 lokalisiert, die entgegengesetzt zur Propagationsrichtung liegt. Häufig sind in einer Hochspannungsanlage mehrere Sensoren 4 angeordnet, sodass der Ort der Teilentladungsquelle relativ gut eingegrenzt werden kann, sodass zur Fehlerbeseitigung nur ein vergleichsweise kleiner Teil der Anlage demontiert werden muss.

Die Fig.5 zeigt schematisch die Signalverläufe, wie sie beispielsweise in den Teilsensoren 5 und 6 in Abhängigkeit von der Propagationsrichtung der Teilentladungsimpulse auftreten. In der obersten Zeile der Figur ist durch die Pfeile die Propagationsrichtung angegeben, und zwar bezogen auf die Fig.1 verläuft die Propagationsrichtung in der breiten linken Spalte in die Zeichnungsebene hinein und in der breiten rechten Spalte aus der Zeichnungsebene heraus. In der nächsten Zeile ist, ebenfalls auf Fig.1 bezogen, die Bezugszeichen-Nummer der Teilsensoren 5 und 6 angegeben. In der nächsten Zeile, die mit E-Signal bezeichnet ist, ist der Verlauf der durch die beiden Teilsensoren 5 und 6 aufgenommenen, vom elektrischen Feld abgeleiteten Signale, dargestellt. In der nächsten Zeile, die mit M-Signal bezeichnet ist, ist der Verlauf der durch die beiden Teilsensoren 5 und 6 aufgenommenen, vom magnetischen Feld abgeleiteten Signale, dargestellt. In der untersten Zeile ist jeweils das resultierende Signal dargestellt, welches sich ergibt, wenn die in der jeweiligen Spalte übereinander dargestellten Signale, das E-Signal und das M-Signal, überlagert werden.

Aus dieser Darstellung ist zu erkennen, dass besonders wirksame resultierende Signale auftreten, wenn das vom elektrischen Feld abgeleitete Signal etwa gleich gross ist wie das vom magnetischen Feld abgeleitete Signal. Die Einbeziehung des vom elektrischen Feld abgeleiteten Signals in die Bildung des resultierenden Signals führt zu besonders deutlichen Signalamplituden, sodass infolgedessen in der Signalverarbeitungsvorrichtung 20 stets eine eindeutige Detektierung der relevanten Teilentladungsimpulse gewährleistet ist.

Die beiden Teilsensoren 5 und 6 des Sensors 4 werden beim Auftreten von hochfrequenten Teilentladungsimpulsen durch das in dem Gehäuse 1 herrschende elektrische Feld beaufschlagt, und zwar in genau gleicher Weise, wenn ein entsprechender gleicher Aufbau dieser Sensoren vorausgesetzt wird. Das durch jeden der beiden Teilsensoren 5 und 6 aufgenommene, kapazitive, vom elektrischen Feld herrührende Signal entspricht genau dem jeweiligen, durch den anderen Teilsensor aufgenommenen kapazitiven Signal. Die beiden Signale sind sowohl nach der Grösse als auch nach der Polarität genau gleich. Sowohl am Anschluss 11 als auch am Anschluss 13 tritt demnach ein dem elektrischen Feld entsprechendes Signal (E-Signal) auf, wie dies in Fig.5 dargestellt ist. Dieses Signal ist unabhängig von der Propagationsrichtung der Teilentladungsimpulse.

Die beiden Teilsensoren 5 und 6 werden jedoch zudem gleichzeitig durch das durch die hochfrequenten Teilentladungsimpulse im Innern des Gehäuses 1 hervorgerufene magnetische Feld beaufschlagt. Die Anschlüsse 11 und 12 des Teilsensors 5 bilden zusammen mit der metallischen Messelektrode 7 eine erste elektrisch leitende Windung, in welcher durch dieses magnetische Feld ein Strom induziert wird. Die Anschlüsse 13 und 14 des Teilsensors 6 bilden zusammen mit der metallischen Messelektrode 8 eine zweite elektrisch leitende Windung, in welcher durch dieses magnetische Feld ein Strom induziert wird. Diese zweite elektrisch leitende Windung, weist, bezogen auf die Richtung des magnetischen Felds, einen der ersten Windung entgegengesetzten Wicklungssinn auf. Sowohl am Anschluss 11 als auch am Anschluss 13 tritt demnach ein dem magnetischen Feld entsprechendes Signal (M-Signal) auf, allerdings weisen, wie dies in Fig.5 dargestellt ist, diese beiden Signale eine unterschiedliche Polarität auf. Diese Signale sind abhängig von der Propagationsrichtung der Teilentladungsimpulse.

An den von den Teilsensoren 5 und 6 abgehenden Anschlüssen 11 und 13 überlagern sich jedoch jeweils die dem elektrischen Feld und dem magnetischen Feld entsprechenden Signale des entsprechenden Teilsensors zu jeweils einem resultierenden Signal (EM-Signal), wie dies in Fig.5 dargestellt ist. Jedes dieser beiden resultierenden Signale wird in den dem betreffenden Teilsensor zugeordneten Zweig der Signalverarbeitungsvorrichtung 20 geleitet.

Die Teilsensoren 5 und 6 sind so angeordnet, dass die Windungen senkrecht oder annähernd senkrecht von dem magnetischen Feld der Teilentladungsimpulse durchsetzt werden. Wegen des auf die Richtung des magnetischen Felds bezogenen unterschiedlichen Wicklungssinns der Windungen der beiden Teilsensoren 5,6 gibt es, abhängig von der Propagationsrichtung der Teilentladungsimpulse, unterschiedliche Signale, welche auch unterschiedliche resultierende Signale (EM-Signale) in den Anschlüssen 11 und 13 zur Folge haben. In dem in Fig.5 gezeigten Beispiel ist die Amplitude des resultierenden Signals im Teilsensor 5 deutlich grösser als die im Teilsensor 6, wenn die Propagationsrichtung in die Zeichnungsebene hinein führt. Führt die Propagationsrichtung jedoch aus der Zeichnungsebene heraus, so wird vom Teilsensor 6 eine deutlich grössere Signalamplitude abgegeben.

Diese resultierenden Signale (EM-Signale) werden parallel zueinander in die Zweige 18 und 19 der Signalverarbeitungsvorrichtung 20 eingespeist. Die beiden Niveaudetektoren 23 und 24 prüfen, ob ein vorgegebener Schwellwert durch eines der resultierenden Signale erreicht, beziehungsweise überschritten wird. Stellt beispielsweise der Niveaudetektor 23 fest, dass beim resultierenden Signal des Teilsensors 5 der vorgegebene Schwellwert erreicht wurde, so wird über das Verbindungsnetzwerk 30 einerseits der zweite Zweig 19 gesperrt, die Gates 27 und 29 sperren ab, und zwar für eine vorgegebene vergleichsweise kurze Zeitdauer, andererseits wird dann auch der erste Zweig 18 für eine vorgegebene vergleichsweise kurze Zeitdauer gesperrt, nachdem der im Niveaudetektor 23 erzeugte Messimpuls in der Speicher- und Verarbeitungseinheit 25 gespeichert wurde. Diese Sperrung des aktiv detektierenden Zweigs 18 erfolgt um zu verhindern, dass in der Speicher- und Verarbeitungseinheit 25 auftretende Reflektionen die Eindeutigkeit der Detektion verfälschen. Würden derartige Reflektionen zugelassen, so würde die für die jeweils detektierte Teilentladungsquelle charakteristische Struktur der Messimpulse, insbesondere im Hinblick auf die zeitlichen Abstände der Impulse, verfälscht. In der Speicher- und Verarbeitungseinheit 25 werden die gespeicherten Messimpulse analysiert, insbesondere im Hinblick darauf ob es lediglich eine einmalige Störung in der Anlage war, die keine Massnahmen erfordert, oder ob diese Teilentladungsquelle häufiger Teilentladungsimpulse verursacht, sodass eine Revision des betroffenen Teils der Hochspannungsanlage vorgesehen werden muss, um grössere Folgeschäden zu vermeiden.

### BEZEICHNUNGSLISTE

- 1: Gehäuse
- 2: Mittelachse
- 3: Vertiefung
- 4: Sensor
- 5,6: Teilsensor
- 7,8: Metallplatte
- 9,10: Kante
- 11,12: Anschluss
- 13,14: Anschluss
- 15: Fläche
- 16: Durchführung
- 17: Ende
- 18,19: Zweig
- 20: Signalverarbeitungsvorrichtung
- 21: Eingangsverstärker
- 22: Gate
- 23: Niveaudetektor
(Locking Level Detector LLD)
- 24: Gate
- 25: Speicher- und Verarbeitungseinheit
- 26: Eingangsverstärker
- 27: Gate
- 28: Niveaudetektor
(Locking Level Detector LLD)
- 29: Gate
- 30: Verbindungsnetzwerk
- a: Abstand
- E-Signal: vom elektrischen Feld abgeleitetes Signal
- M-Signal: vom magnetischen Feld abgeleitetes Signal
- EM-Signal: resultierendes Signal

## Patentansprüche

1. Sensor zum Auskoppeln von Teilentladungsimpulsen aus einer hochspannungsführenden elektrischen Anlage, insbesondere einer metallgekapselten gasisolierten Hochspannungsanlage, welcher sowohl für die Nutzung des durch die Teilentladungsimpulse verursachten elektrischen Felds als auch für die Nutzung des durch die Teilentladungsimpulse verursachten magnetischen Felds für die Detektion von den Teilentladungsimpulsen ausgelegt ist, **dadurch gekennzeichnet dass** der Sensor (4) zwei Teilsensoren (5,6) mit jeweils mindestens einer flächig ausgebildeten, dem elektromagnetischen Feld der Anlage ausgesetzten Messelektrode (7,8) aufweist, wobei jeder der zwei Teilsensoren (5,6), die Signale von jeweils dem elektrischen und magnetischen Feld ableiten, mit Mitteln versehen ist für die Detektion des magnetischen Felds, und wobei jeder der zwei Teilsensoren (5,6) mit jeweils mindestens einem separaten Eingang einer Signalverarbeitungsvorrichtung (20) verbunden ist, wobei
- die zwei Teilsensoren (5,6) identisch aufgebaut und um 180° gegeneinander verdreht montiert sind.

2. Sensor nach Anspruch 1, **dadurch gekennzeichnet,**
- **dass** als Mittel für die Detektion des magnetischen Felds pro Teilsensor (5,6) mindestens eine elektrisch leitende Windung vorgesehen ist.

3. Sensor nach Anspruch 2, **dadurch gekennzeichnet,**
- **dass** die mindestens eine elektrisch leitende Windung so angeordnet ist, dass sie von dem magnetischen Feld der Teilentladungsimpulse senkrecht oder annähernd senkrecht durchsetzt wird.

4. Sensor nach Anspruch 1, **dadurch gekennzeichnet,**
- **dass** die Eingänge der Signalverarbeitungsvorrichtung (20) gegeneinander blockierbar ausgebildet sind.

5. Sensor nach Anspruch 1, **dadurch gekennzeichnet,**
- **dass** die zwei Teilsensoren (5,6) so ausgebildet sind, dass das vom elektrischen Feld abgeleitete Signal etwa gleich gross ist wie das vom magnetischen Feld abgeleitete Signal.

6. Verfahren zur Bestimmung der Propagationsrichtung von Teilentladungsimpulsen, bei dem in einem hierfür verwendeten, gemäss Patentanspruch 4 ausgebildeten Sensor (4), wobei sowohl das elektrische Feld als auch das magnetische Feld für die Detektion der Teilentladungsimpulse genutzt wird,
- und wobei jeweils nur ein erster Eingang der mit dem Sensor (4) zusammenwirkenden Signalverarbeitungsvorrichtung (20) einen Messimpuls generiert, bei dem zuerst ein vorgegebener Schwellwert erreicht oder überschritten wird, und wobei
- ein mindestens zweiter Eingang der Signalverarbeitungsvorrichtung (20) danach sofort während einer vorgegebenen Zeitspanne gesperrt wird.

7. Verfahren nach Anspruch 6, **dadurch gekennzeichnet,**
- **dass** nach dem Speichern des Messimpulses in einer Speicher- und Verarbeitungseinheit (25) der erste Eingang der Signalverarbeitungsvorrichtung (20) gleichfalls während einer vorgegebenen Zeitspanne gesperrt wird.

## Claims

1. Sensor for coupling partial discharge pulses out of a high-voltage-carrying electrical installation, in particular a metal-enclosed gas-insulated high-voltage installation, which sensor is designed not only to use the electric field covered by the partial discharge pulses but also to use the magnetic field covered by the partial discharge pulses for detecting the partial discharge pulses **characterized in that** the sensor (4) has two partial sensors (5, 6) which each have at least one measuring electrode (7, 8) of planar construction which is exposed to the electromagnetic field of the installation, each of the two partial sensors (5, 6), which derive signals from the electric field and the magnetic field in each case, being provided with means for detecting the magnetic field, and each of the two partial sensors (5, 6) being connected in each case to at least one separate input of a signal processing system (20), the two partial sensors (5, 6) having an identical structure and being mounted such that they are rotated through 180° with respect to one another.

2. Sensor according to Claim 1, **characterized in that**
- at least one electrically conductive turn is provided for each partial sensor (5, 6) as a means for detecting the magnetic field.

3. Sensor according to Claim 2, **characterized in that**
- the at least one electrically conductive turn is arranged in such a way that it is permeated perpendicularly or approximately perpendicularly by the magnetic field of the partial discharge pulses.

4. Sensor according to Claim 1, **characterized in that**
- the inputs of the signal processing system (20) are designed so that they can be blocked with respect to one another.

5. Sensor according to Claim 1, **characterized in that**
- the two partial sensors (5, 6) are constructed in such a way that the signal derived from the electric field is approximately the same in magnitude as the signal derived from the magnetic field.

6. Method for determining the propagation direction of partial discharge pulses, wherein in a sensor (4) designed according to Patent Claim 4 and used therefor, both the electric field and the magnetic field are used for detecting the partial discharge pulses,
- and only a first input of the signal processing system (20) interacting with the sensor (4) generates in each case a measurement pulse, in the case of which a predetermined threshold value is initially reached or exceeded, and
- an at least second input of the signal processing system (20) is subsequently immediately inhibited during a predetermined time interval.

7. Method according to Claim 6, **characterized in that**
- after the measurement pulse has been stored in a memory and processing unit (25), the first input of the signal processing system (20) is likewise inhibited during a predetermined time interval.

## Revendications

1. Capteur pour découpler des impulsions de décharge partielle en provenance d'un équipement électrique à haute tension, notamment un équipement à haute tension en blindage métallique à isolement gazeux, lequel est conçu pour utiliser le champ électrique provoqué par les impulsions de décharge partielle ainsi que pour utiliser le champ magnétique provoqué par les impulsions de décharge partielle pour la détection des impulsions de décharge partielle, **caractérisé en ce que** le capteur (4) présente deux capteurs partiels (5, 6) comportant chacun au moins une électrode de mesure (7, 8) de forme plate exposée au champ électromagnétique de l'équipement, chacun des deux capteurs partiels (5, 6), lesquels dérivent les signaux respectifs du champ électrique et du champ magnétique, étant muni de moyens pour la détection du champ magnétique, et chacun des deux capteurs partiels (5, 6) étant relié à chaque fois avec au moins une entrée séparée d'un dispositif de traitement du signal (20), les deux capteurs partiels (5, 6) étant de construction identique et montés en étant pivotés de 180° l'un par rapport à l'autre.

2. Capteur selon la revendication 1, **caractérisé en ce qu'**au moins une spire conductrice d'électricité est prévue par capteur partiel (5, 6) comme moyen de détection du champ magnétique.

3. Capteur selon la revendication 2, **caractérisé en ce que** l'au moins une spire conductrice d'électricité est disposée de manière à être traversée perpendiculairement ou presque perpendiculairement par le champ magnétique des impulsions de décharge partielle.

4. Capteur selon la revendication 1, **caractérisé en ce que** les entrées du dispositif de traitement du signal (20) sont configurées de manière à pouvoir être bloquées réciproquement.

5. Capteur selon la revendication 1, **caractérisé en ce que** les deux capteurs partiels (5, 6) sont configurés de telle manière que le signal dérivé du champ électrique est à peu près aussi grand que le signal dérivé du champ magnétique.

6. Procédé de détermination du sens de propagation des impulsions de décharge partielle avec lequel le champ électrique et le champ magnétique sont tous deux utilisés dans un capteur employé à cet effet et configuré selon la revendication 4 pour la détection des impulsions de décharge partielle et avec lequel une première entrée respective seulement du dispositif de traitement du signal (20) qui agit conjointement avec le capteur (4) génère une impulsion de mesure avec laquelle une valeur de seuil prédéfinie est tout d'abord atteinte ou dépassée, et avec lequel au moins une deuxième entrée du dispositif de traitement du signal (20) est ensuite bloquée immédiatement pendant un intervalle de temps prédéfini.

7. Procédé selon la revendication 6, **caractérisé en ce qu'**après l'enregistrement de l'impulsion de mesure dans une unité de mémorisation et de traitement (25), la première entrée du dispositif de traitement du signal (20) est elle aussi bloquée pendant un intervalle de temps prédéfini.
